# EUROPEAN PATENT APPLICATION

(11) **EP 2 477 245 A2**
(43) Date of publication of application: **18.07.2012**
(21) Application number: 12150865.9
(22) Date of filing: 12.01.2012
(51) Int. Cl.: H01L 33/62, H01L 33/48

(54) **Light emitting diode package**

(30) Priority: 13.01.2011 KR 20110003554
(71) Applicant: Samsung LED Co., Ltd., Gyeonggi-do 443-743 (KR)
(72) Inventor: Choi, Ki-won, Gyeonggi-do (KR)
(74) Representative: Grünecker, Kinkeldey, Stockmair & Schwanhäusser

(57) **Abstract**

A light-emitting diode package (100) comprises: a substrate (110) including a first surface (110a) and a second surface (110b); a light-emitting chip (160) mounted on the first surface; and an electrode pad portion (140) that is disposed on the second surface and electrically connects the light-emitting chip to an external device, wherein the electrode pad portion has a shape with rotational symmetry with respect to a predetermined angle when a normal line running through a center of the second surface is used as a rotation axis.

## Description

### CROSS-REFERENCE TO RELATED APPLICATIONS

This application claims the benefit of Korean Patent Application No. 10-2011-0003554, filed on January 13, 2011, in the Korean Intellectual Property Office, the disclosure of which is incorporated herein in its entirety by reference.

### BACKGROUND

### 1. Field

The present disclosure relates to light-emitting device packages.

### 2. Description of the Related Art

Light-emitting devices (LED) refer to semiconductor devices that generate various colors of light by using a light source formed via a PN junction of a compound semiconductor.

LEDs have long lifetimes and are manufactured as small and lightweight devices, and also have a strong directional property of light, thereby enabling driving at low voltages. Also, LEDs are strongly resistant to impacts and vibrations, do not require a preheating time and complicated driving, and are able to be packaged in various shapes. Due to these features, they are applicable for various purposes.

Packages for an LED are required to have good heat dissipation characteristics and to be small and lightweight. Also, with respect to an SMD type package, when an LED is mounted on a board of a set or module board, soldering is used for connection with the board. In this case, improper mounting may occur. For example, the package may rotate according to a size or shape of a connection pad and may not match with positive (+) and negative (-) electrode directions, or deformation in one direction may occur and affect a heat dissipation pathway. Such cases of improper mounting lead to a defective product.

### SUMMARY

Provided are light-emitting device packages having package electrode structures for reducing defective mounting.

Additional aspects will be set forth in part in the description which follows and, in part, will be apparent from the description, or may be learned by practice of the presented embodiments.

According to an aspect of the present invention, a light-emitting device package includes a substrate including a first surface and a second surface; a light-emitting chip mounted on the first surface; and an electrode pad portion that may be disposed on the second surface and electrically connects the light-emitting chip to an external device, wherein the electrode pad portion may have a shape with rotational symmetry with respect to a predetermined angle when a normal line running through a center of the second surface may be used as a rotation axis..

The electrode pad portion may include: an inner electrode that may be disposed on a central portion of the second surface and may have a shape with the rotational symmetry; and an outer electrode that may be spaced apart from and surrounds the inner electrode.

The light-emitting device package may further including first and second upper electrodes disposed on the first surface, wherein the first upper electrode may be electrically connected to the inner electrode and the second upper electrode may be electrically connected to the outer electrode. In this case, the light-emitting device package may further including: a first conductive via that passes through the substrate and electrically connects the inner electrode and the first upper electrode; and a second conductive via that passes through the substrate and electrically connects the outer electrode and the second upper electrode.

The outer electrode may include a plurality of regions spaced apart from each other. In this case, an outer shape of the second surface may be rectangular, and the regions of the outer electrode may be disposed respectively corresponding to four corners of the rectangular shape, and each of the regions may have a circular-shape, a letter '¬'- shape, or a triangle-shape.

Alternatively, an outer shape of the second surface may be rectangular and the regions of the outer electrode may be disposed respectively corresponding to four sides of the rectangular shape and each region may have a square shape having sides parallel to the four sides.

Alternatively, an outer shape of the second surface may be rectangular and the regions of the outer electrode may be disposed respectively corresponding to corners of the rectangular shape.

The light-emitting device package may be further including first and second upper electrodes disposed on the first surface, wherein the first upper electrode may be electrically connected to the inner electrode and the second upper electrode may be electrically connected to the outer electrode. In this case, the light-emitting device package may further including: a first conductive via that passes through the substrate and electrically connects the inner electrode and the first upper electrode; and a plurality of second conductive vias that pass through the substrate and electrically connect the outer electrode and the second upper electrode.

The second upper electrode may include a plurality of regions spaced apart from each other. In this case, the light-emitting device package may further include: a first conductive via that passes through the substrate and electrically connects the inner electrode and the first upper electrode; and a plurality of second conductive vias that pass through and electrically connect the outer electrode and each of the regions of the second upper electrode.

An outer shape of the second surface may be square, and the inner electrode may have a shape with rotational symmetry with respect to an angle of 90°. For example, the inner electrode may have a circular shape, a rhombus shape, or a regular polygonal shape of which a number of sides thereof may be 2N (N is an even number).

An outer shape of the second surface may be rectangular and the inner electrode may have rotational symmetry with respect to an angle of 180°. For example, the inner electrode may have a circular shape, an oval shape, a rhombus shape, or a regular polygonal shape of which a number of sides may be 2N (N is a natural number).

According to another aspect of the present invention, a light-emitting device set board includes the light-emitting device package described above, and a land portion on which the light-emitting device package may be mounted..

The land portion may include: an inner land that contacts the inner electrode; and an outer land that contacts the outer electrode, and the outer land may have a shape including a plurality of divided regions.

### BRIEF DESCRIPTION OF THE DRAWINGS

These and/or other aspects will become apparent and more readily appreciated from the following description of the embodiments, taken in conjunction with the accompanying drawings of which:

FIG. 1 is a cross-sectional view of a light-emitting device package according to an embodiment of the present invention;

FIG. 2A is a top view of the light-emitting device package of FIG. 1;

FIG. 2B is a bottom view of the light-emitting device package of FIG. 1;

FIG. 3 is a view of a light-emitting device set board according to an embodiment of the present invention, illustrating a corresponding relationship between the light-emitting device package of FIG. 1 and a land portion of a set board when the light-emitting device package is mounted on the set board;

FIGS. 4A and 4B respectively illustrate locations of a light-emitting device package when the light-emitting device package is positioned in a proper location and when the light-emitting device package is rotated by an angle of 180° to explain a corresponding relationship between the light-emitting device package and the land portion of FIG. 3.

FIG. 5 illustrates another example of the land portion of FIG. 3;

FIGS. 6 to 9 illustrate various examples of the shape of an upper electrode of the light-emitting device package of FIG. 1; and

FIGS. 10 to 18 illustrate various examples of the shape of an electrode pad portion formed on a lower surface of the light-emitting device package of FIG. 1.

### DETAILED DESCRIPTION

Reference will now be made in detail to embodiments, examples of which are illustrated in the accompanying drawings, wherein like reference numerals refer to like elements throughout and sizes or thicknesses of the respective elements may be exaggerated for clarity. In this regard, the present embodiments may have different forms and should not be construed as being limited to the descriptions set forth herein. Accordingly, the embodiments are merely described below, by referring to the figures, to explain aspects of the present invention.

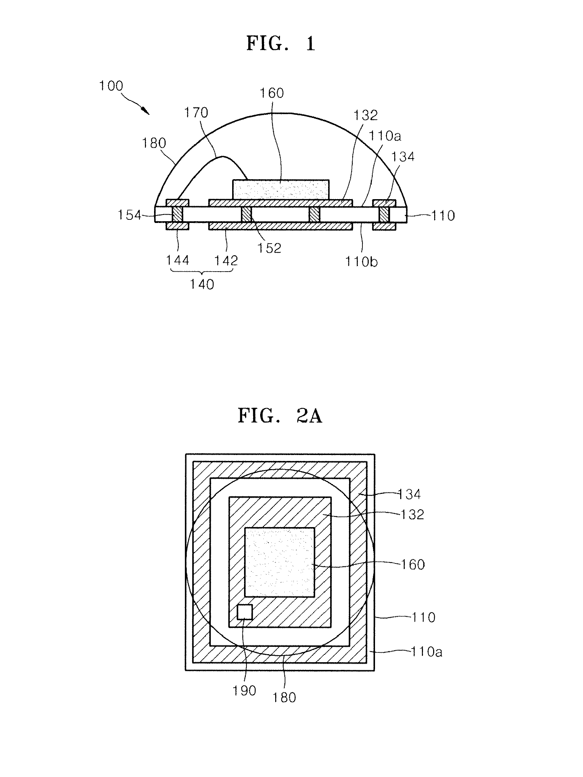

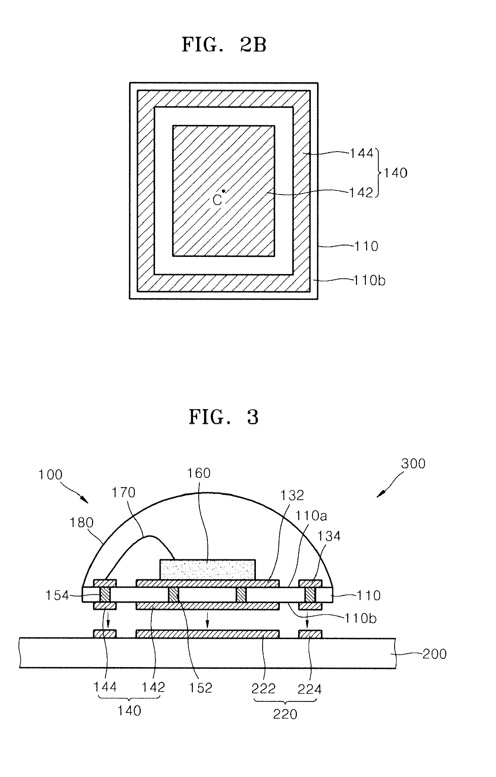

FIG. 1 is a cross-sectional view of a light-emitting device package 100 according to an embodiment of the present invention, and FIGS. 2A and 2B are respectively top and bottom views of the light-emitting device package 100 of FIG. 1.

Referring to FIGS. 1, 2A, and 2B, the light-emitting device package 100 includes a substrate 110 having first and second surface 110a and 110b facing each other, a light-emitting chip 160 disposed on the first surface 110a, and an electrode pad portion 140 that is disposed on the second surface 110b and electrically connects the light-emitting chip 160 to an external device.

In the present embodiment, the electrode pad portion 140 has a pattern that minimizes occurrence of a defective product when the light-emitting device package 100 is mounted on an external device. To do this, the electrode pad portion 140 may have a shape with rotational symmetry with respect to a predetermined angle when a normal line running through a center C of the second surface 110b is used as a rotation axis. In this case, even when the light-emitting device package 100 is mounted misaligned by the predetermined angle on an external device, the mounting is not defective because it is not distinguished from a proper mounting.

The electrode pad portion 140 is disposed on a central portion of the second surface 110b and may include an inner electrode 142 that has a rotationally symmetric shape and an outer electrode 144 that is spaced apart from and surrounds the inner electrode 142. For example, as illustrated in FIG. 2B, the inner electrode 142 is rectangular and the outer electrode 144 may surround the inner electrode 142, spaced therefrom.

Also, a first upper electrode 132 that is electrically connected to the inner electrode 142 and a second upper electrode 134 that is electrically connected to the outer electrode 144 may be disposed on the first surface 110a. In this case, the light-emitting device package 100 may further include a first conductive via 152 that passes through the substrate 110 and electrically connect the inner electrode 142 and the first upper electrode 132, and a second conductive via 154 that passes through the substrate 110 and electrically connect the outer electrode 144 and the second upper electrode 134. The number of first conductive vias 152 or the number of second conductive vias 154 is not limited to the illustrated structure. Also, in FIG. 1, the shape of the inner electrode 142 is identical to the shape of the first upper electrode 132 and the shape of the outer electrode 144 is identical to the shape of the second upper electrode 134. However, the shapes of are not limited thereto. For example, the inner electrode 142 and the first upper electrode 132 may have various other shapes that forms an electric path therebetween via the first conductive via 152 and the outer electrode 144 and the second upper electrode 134 may have various other shapes that forms an electric path therebetween via the second conductive via 154.

The light-emitting chip 160 may include a light-emitting layer formed of a compound semiconductor and a positive (+) electrode and a negative (-) electrode disposed at opposite ends of the light-emitting layer, and when a voltage is applied to the light-emitting chip 160, a predetermined color of light may be emitted according to a material that forms the light-emitting layer. The light-emitting chip 160 may be disposed on the first upper electrode 132 in such a way that the negative (-) electrode is electrically connected to the first upper electrode 132, and the positive (+) electrode of the light-emitting chip 160 is connected to the second upper electrode 134 via a wire 170. Because the first upper electrode 132 is electrically connected to the inner electrode 142 via the first conductive via 152 and the second upper electrode 134 is electrically connected to the outer electrode 144 via the second conductive via 154, the electrode pad portion 140, which includes the inner electrode 142 and the outer electrode 144, electrically connects the light-emitting chip 160 to an external device and applies a voltage to the negative (-) electrode and the positive (+) electrode of the light-emitting chip 160. Hereinbefore, the inner electrode 142 has been described as having a negative (-) polarity and the outer electrode 144 has been described as having a positive (+) polarity. However, according to the design or arrangement of the positive (+) and negative (-) electrodes of the light-emitting chip 160, the polarities may be switched with each other.

Also, a zener diode 190 may be further disposed on the first upper electrode 132 as a semiconductor device that protects the light-emitting chip 160 from static electricity.

Also, a cover layer 180 having a lens shape may be further disposed to protect the light-emitting chip 160 and control a directional property of light emitted from the light-emitting chip 160. The shape of the cover layer 180 is not limited to the illustrated shape and, for example, the light-emitting chip 160 may have a flat shape to only protect the light-emitting chip 160 not to function as a lens.

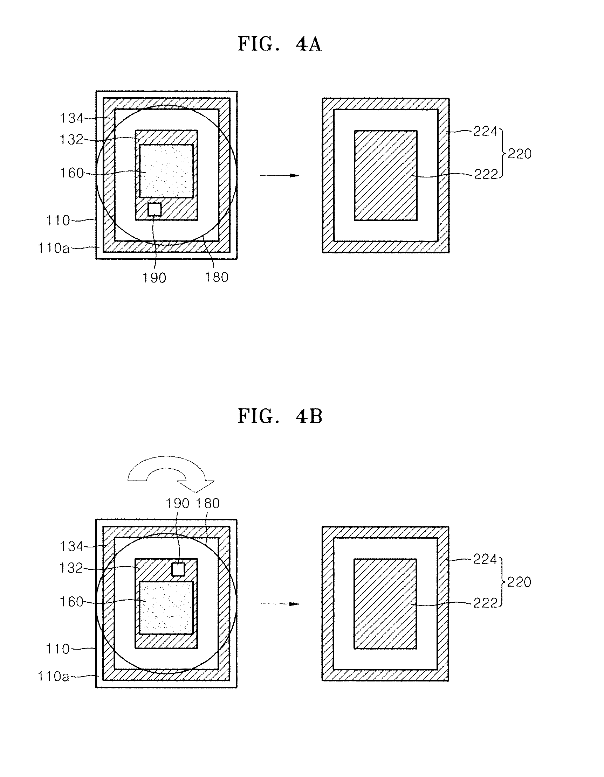

FIG. 3 is a view of a light-emitting device set board 300 according to an embodiment of the present invention to explain a corresponding relationship between the light-emitting device package 100 of FIG. 1 and a land portion 220 of a set board 200 when the light-emitting device package 100 of FIG. 1 is mounted on the set board 200. Also, FIGS. 4A and 4B illustrate locations of the light-emitting device package 100 when the light-emitting device package 100 is positioned in a proper location and when the light-emitting device package 100 is rotated by an angle of 180° to explain a corresponding relationship between the light-emitting device package 100 and the land portion 220.

Referring to FIG. 3, the light-emitting device set board 300 includes the light-emitting device package 100 and the set board 200 including the land portion 220 on which the light-emitting device package 100 is mounted. The land portion 220 includes an inner land 222 and an outer land 224 respectively corresponding to the shapes of the inner electrode 142 and the outer electrode 144 of the light-emitting device package 100. That is, as illustrated in FIG. 3, the land portion 220 includes the inner land 222 contacting the inner electrode 142 and the outer land 224 contacting the outer electrode 144.

Due to the shapes of the inner and outer electrodes 142 and 144 on a bottom surface (that is, the second surface 110b) of the light-emitting device package 100, the possibility of defective mounting when the light-emitting device package 100 is mounted on the set board 200 may substantially decrease. For example, as illustrated in FIG. 4B, even when the light-emitting device package 100 contacts the land portion 220 after the light-emitting device package 100 is rotated by an angle of 180°, its electric polarity is not different from a case illustrated in FIG. 4A, the light-emitting device package 100 is in the proper position and contacts the land portion 220 of the set board 200, and thus the contact is substantially equivalent to the proper contact. In FIG. 2B, the second surface 110b of the light-emitting device package 100 has a rectangular outer shape. However, the second surface 110b may instead have a square shape, and in this case, the second surface 110b may have rotational symmetry with respect to an angle of 90°, and defective mounting may less likely occur.

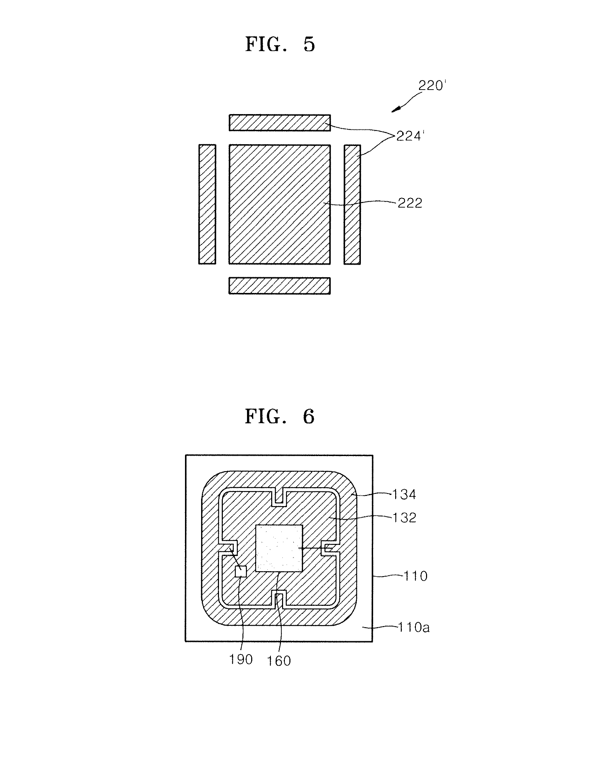

FIG. 5 is a view of a land portion 220' having a shape different from the land portion 220 as an example of the land portion 200. The land portion 220' may have various shapes according to a structure of a set board, for example, a single-layer PCB or double-layer PCB, or a soldering process. As illustrated in FIG. 5, an outer land 224' may include a plurality of divided regions. This structure is adopted to separate an outer land to connect patterns on a PCB on a package mounted surface with the inner land 222 when a single-layer PCB is used.

Unlike this structure, as illustrated in FIGS. 4A and 4B, if the outer land 224 is integrally formed as one body, a voltage may be applied from other layers to the inner land 222 through a viahole.

FIGS. 6 to 9 illustrate various examples of the first and second upper electrodes 132 and 134 formed on an upper surface of the light-emitting device package 100 of FIG. 1, that is, the first surface 110a.

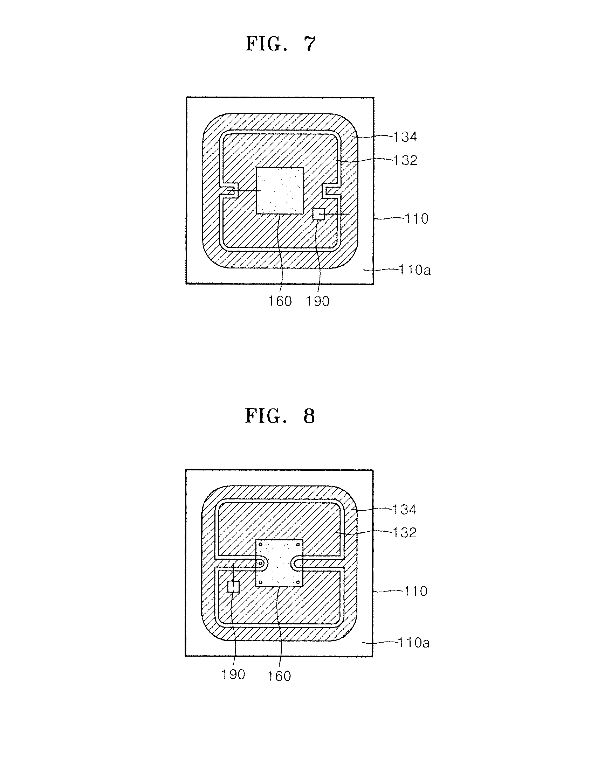

Referring to FIGS. 6 and 7, the first upper electrode 132 may have a tetragonal shape having indented portions at a central portion of four or two sides thereof and the second upper electrode 134 has protruding portions corresponding to the inlet portions. The indented and protruding shapes may be formed in consideration of, for example, convenience of wire bonding between the light-emitting chip 160 and the zener diode 190.

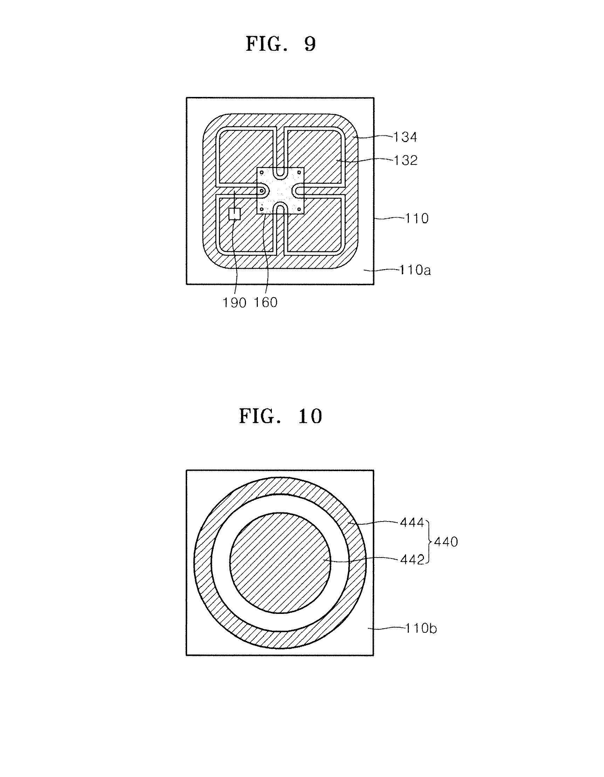

FIGS. 8 and 9 illustrate a case in which the light-emitting chip 160 is subjected to flip-chip bonding and the first upper electrode 132 has a tetragonal shape having indented portions at a central portion of two or four sides thereof and the second upper electrode 134 has protruding portions corresponding to the indented portions. Because the positive (+) and negative (-) electrodes of the light-emitting chip 160 respectively directly contact the first upper electrode 132 and the second upper electrode 134 without wire-bonding, lengths of the indented portions of the first upper electrode 132 or lengths of the protruding portions of the second upper electrode 134 may be longer than the corresponding structures described with reference to FIGS. 6 and 7.

FIGS. 10 to 19 illustrate various shapes of the electrode pad portion 140 formed on the bottom surface of the light-emitting device package 100 of FIG. 1.

An electrode pad portion 440 illustrated in FIG. 10 includes an inner electrode 442 having a circular shape and an outer electrode 444 that has a ring shape and is spaced from the inner electrode 442 by a predetermined distance. If the second surface 110b has a square outer shape, the electrode pad portion 440 may have rotational symmetry with respect to an angle of 90°.

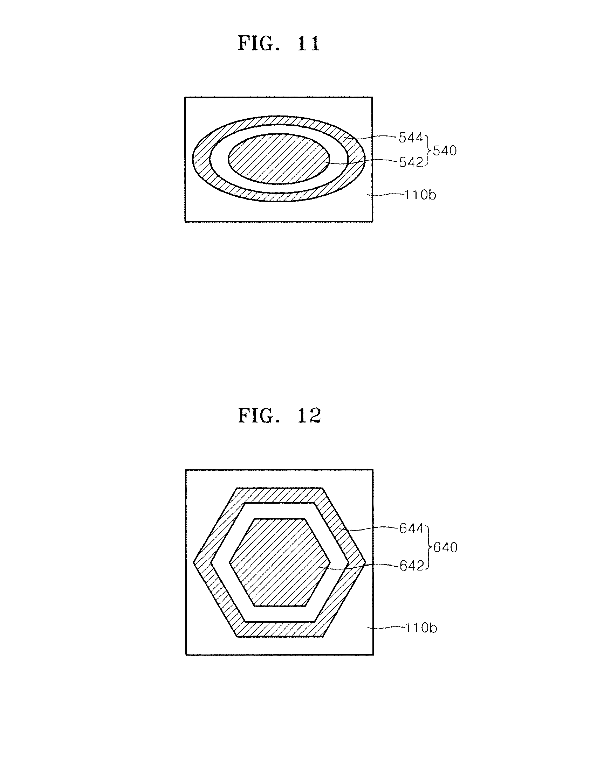

An electrode pad portion 540 illustrated in FIG. 11 includes an inner electrode 542 having an oval shape and an outer electrode 544 that has an oval ring shape and is spaced apart from the inner electrode 542 by a predetermined distance. The electrode pad portion 540 may have rotational symmetry with respect to an angle of 180°.

An electrode pad portion 640 illustrated in FIG. 12 includes an inner electrode 642 having a regular hexagonal shape and an outer electrode 644 surrounding the inner electrode 642, being spaced from the inner electrode 642 having the regular hexagonal shape by a predetermined distance. The electrode pad portion 640 may have rotational symmetry with respect to an angle of 180°. Although the illustrated inner electrode 642 has the regular hexagonal shape, even when the inner electrode 642 has a rhombus shape or a regular polygonal shape of which the number of sides is 2N (N is a natural number), the electrode pad portion 640 may also have rotational symmetry with respect to an angle of 180°.

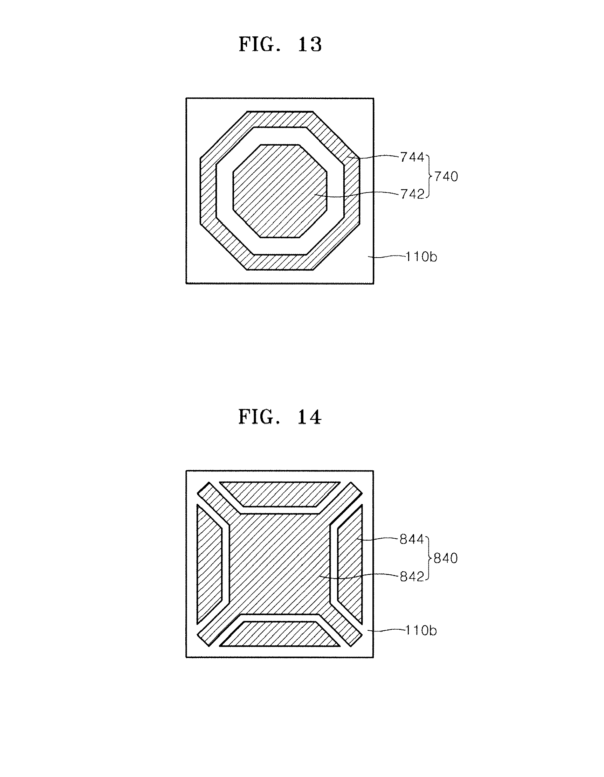

An electrode pad portion 740 illustrated in FIG. 13 includes an inner electrode 742 having a regular octagonal shape and an outer electrode 744 surrounding the inner electrode 742, being spaced from the inner electrode 742 having the regular octagonal shape by a predetermined distance. If the outer shape of the second surface 110b is square, the electrode pad portion 740 may have rotational symmetry with respect to an angle of 90°. Although the illustrated inner electrode 742 has the regular octagonal shape, even when the outer shape of the second surface 110b is square and the inner electrode 742 has a regular polygonal shape of which the number of sides is 2N (N is an even number), the electrode pad portion 740 may also have rotational symmetry with respect to an angle of 90°.

The electrode pad portions 440, 540, 640, and 740 illustrated in FIGS. 10 to13 may be electrically connected to the first upper electrode 132 and the second upper electrode 134, which have been described with reference to FIGS. 2A and 6-9, via the first conductive via 152 and the second conductive via 154. Also, because each of the outer electrodes 444, 544, 644, and 744 of the electrode pad portions 440, 540, 640, and 740 are formed in only one region, the corresponding second upper electrode 134 may have a shape that is divided into a plurality of regions, in addition to the shapes illustrated in FIGS. 2A and 6-9. In this case, the regions are electrically connected to each of the outer electrodes 444, 544, 644, and 744 via the second conductive via 154.

Referring to FIGS. 14 to 18, outer electrodes 844, 1044, 1144, 1244, and 1344 of electrode pad portions 840, 1040, 1140, 1240, and 1340 each include a plurality of regions spaced apart from each other. For example, an outer shape of a second surface on which each of the electrode pad portions 840, 1040, 1140, 1240, and 1340 is formed is rectangular and the regions on which each of the outer electrode 844, 1044, 1144, 1244, and 1344 are formed may be disposed corresponding to four corners or four sides of the rectangular shape. When each of the outer electrodes 844, 1044, 1144, 1244, and 1344 includes a plurality of regions, each of the regions is connected to the second upper electrode 134 via the second conductive via 154 and the second upper electrode 134 is required to be formed in only one region.

In detail, referring to FIG. 14, an inner electrode 842 has a square shape having four corners that protrude in diagonal directions and the outer electrode 844 is spaced apart form the inner electrode 842 by a predetermined distance and disposed respectively corresponding to four sides of the second surface 110b.

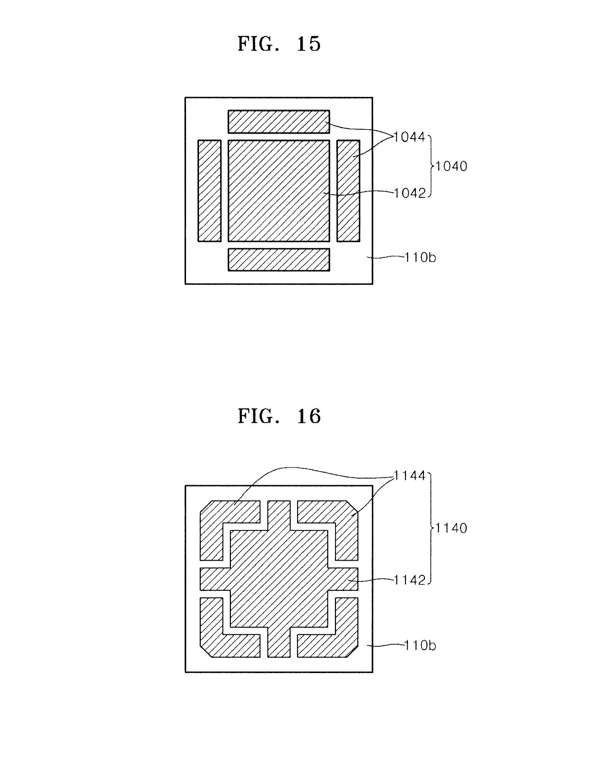

Referring to FIG. 15, an inner electrode 1042 has a square shape and an outer electrode 1044 includes four regions each having a rectangular shape and respectively spaced from four sides of the inner electrode 1042 having the square shape. The square shape may have sides parallel to the four sides of the inner electrode 1042.

Referring to FIG. 16, an inner electrode 1142 has a square shape that has four sides each having a protruding central portion and an outer electrode 1144 including a plurality of letter '¬'-shaped regions spaced apart from the inner electrode 1142 by a predetermined distance between adjacent protruding portions.

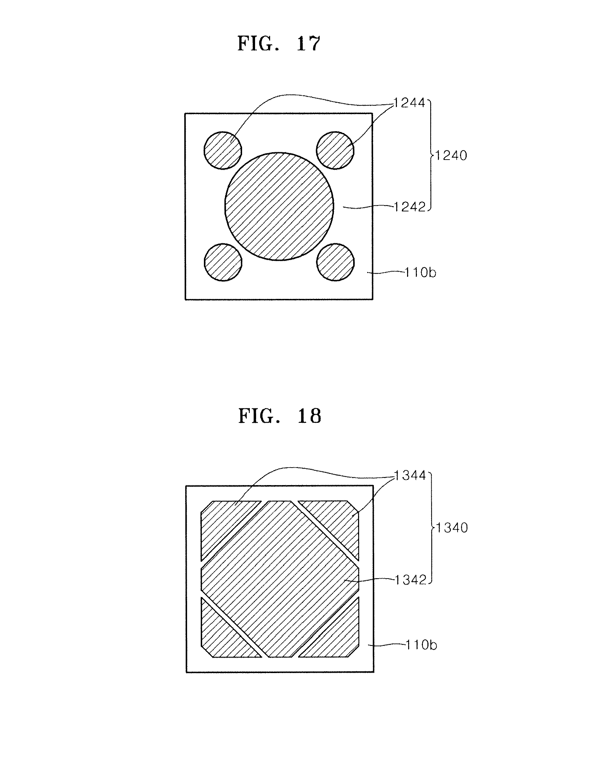

Referring to FIG. 17, an inner electrode 1242 has a circular shape and an outer electrode 1244 includes four circular regions adjacent to four corners of the second surface 110b.

Referring to FIG. 18, the inner electrode 1342 has a rhombus shape and an outer electrode 1344 includes four triangle regions adjacent to four corners of the second surface 110b.

The electrode pad portions 840, 1040, 1140, 1240, and 1340 exemplarily illustrated in FIGS. 14 to 18 may be combined with the first and second upper electrodes 132 and 134 described with reference to FIGS. 6 to 9 in various manners.

Hereinbefore, various shapes of an electrode pad portion disposed on a lower surface of a light-emitting device package have been described. However, the shapes are only examples. The electrode pad portion may instead have various other shapes with rotational symmetry.

The light-emitting device packages according to the above embodiments of the present invention have an improved package electrode pattern to minimize the possibility of defective mounting. For example, even in the case of 90° or 180° rotational mounting, electrical defects do not occur. Thus, an additional examination process is not necessary and productivity may be improved.

It should be understood that the exemplary embodiments of a light-emitting device package according to the present invention described herein should be considered in a descriptive sense only and not for purposes of limitation. Descriptions of features or aspects within each embodiment should typically be considered as available for other similar features or aspects in other embodiments.

## Claims

1. A light-emitting device package comprising:
a substrate including a first surface and a second surface, the first surface and the second surface are opposite to each other;
a light-emitting chip mounted on the first surface; and
an electrode pad portion that is disposed on the second surface and electrically connects the light-emitting chip to an external device,
wherein the electrode pad portion has a shape with rotational symmetry with respect to a predetermined angle when a normal line running through a center of the second surface is used as a rotation axis.

2. The light-emitting device package of claim 1, wherein the electrode pad portion comprises:
an inner electrode that is disposed on a central portion of the second surface and has a shape with the rotational symmetry; and
an outer electrode that is spaced apart from and surrounds the inner electrode.

3. The light-emitting device package of claim 2, further comprising first and second upper electrodes disposed on the first surface,
wherein the first upper electrode is electrically connected to the inner electrode and the second upper electrode is electrically connected to the outer electrode.

4. The light-emitting device package of claim 3, further comprising:
a first conductive via that passes through the substrate and electrically connects the inner electrode and the first upper electrode; and
a second conductive via that passes through the substrate and electrically connects the outer electrode and the second upper electrode.

5. The light-emitting device package of claim 3, wherein the outer electrode comprises a plurality of regions spaced apart from each other.

6. The light-emitting device package of claim 5, wherein an outer shape of the second surface is rectangular, and
the regions of the outer electrode are disposed respectively corresponding to four corners of the rectangular shape.

7. The light-emitting device package of claim 6, wherein each of the regions has a circular-shape, a letter '¬'- shape, or a triangle-shape.

8. The light-emitting device package of claim 5, wherein an outer shape of the second surface is rectangular, and
the regions of the outer electrode are disposed respectively corresponding to four sides of the rectangular shape and each region has a square shape having sides parallel to the four sides.

9. The light-emitting device package of claim 5, further comprising first and second upper electrodes disposed on the first surface,
wherein the first upper electrode is electrically connected to the inner electrode and the second upper electrode is electrically connected to the outer electrode.

10. The light-emitting device package of claim 9, further comprising:
a first conductive via that passes through the substrate and electrically connects the inner electrode and the first upper electrode; and
a plurality of second conductive vias that pass through the substrate and electrically connect the outer electrode and the second upper electrode.

11. The light-emitting device package of claim 3, wherein the second upper electrode comprises a plurality of regions spaced apart from each other.

12. The light-emitting device package of claim 11, further comprising:
a first conductive via that passes through the substrate and electrically connects the inner electrode and the first upper electrode; and
a plurality of second conductive vias that pass through and electrically connect the outer electrode and each of the regions of the second upper electrode.

13. A light-emitting device set board comprising the light-emitting device package of claim 2, and a land portion on which the light-emitting device package is mounted.

14. The light-emitting device set board of claim 13, wherein the land portion comprises:
an inner land that contacts the inner electrode; and
an outer land that contacts the outer electrode.
